Europäisches Patentamt

European Patent Office

Office européen des brevets

(19)

(11) Numéro de publication: **0 276 594 B1**

## FASCICULE DE BREVET EUROPEEN

(12)

(45) Date de publication de fascicule du brevet:
06.11.91

(51) Int. Cl.⁵: **H04N 5/217**, H01L 27/14

(21) Numéro de dépôt: 87402819.4

(22) Date de dépôt: 11.12.87

(54) Dispositif anti-éblouissement pour capteur d'images à transfert de charges, et capteur d'images comportant un tel dispositif.

(30) Priorité: 16.12.86 FR 8617572

(43) Date de publication de la demande:
03.08.88 Bulletin 88/31

(45) Mention de la délivrance du brevet:
06.11.91 Bulletin 91/45

(84) Etats contractants désignés:
DE GB NL

(56) Documents cités:
EP-A- 0 083 376

PATENT ABSTRACTS OF JAPAN, vol. 8, no.
74 (E-236)[1511], 6 avril 1984; & JP-A-58 220
573

PATENT ABSTRACTS OF JAPAN, vol. 6, no.
87 (E-108)[965], 25 mai 1982; & JP-A-57 21 878

(73) Titulaire: THOMSON-CSF
51, Esplanade du Général de Gaulle
F-92800 Puteaux(FR)

(72) Inventeur: Boucharlat, Gilles
THOMSON-CSF SCPI 19, avenue de Messine
F-75008 Paris(FR)
Inventeur: Chabbal, Jean-Joseph
THOMSON-CSF SCPI 19, avenue de Messine
F-75008 Paris(FR)
Inventeur: Cazaux, Yvon
THOMSON-CSF SCPI 19, avenue de Messine
F-75008 Paris(FR)

(74) Mandataire: Turlèque, Clotilde et al
THOMSON-CSF SCPI
F-92045 PARIS LA DEFENSE CEDEX 67(FR)

## Description

L'invention concerne un dispositif anti-éblouissement pour capteurs d'images à transfert de charges, tels que ceux utilisés dans les caméras de télévision. Dans un tel capteur d'images, une rangée ou une matrice d'éléments photosensibles reçoit de la lumière portant une image. Cette lumière libère des charges dans chaque élément photosensible proportionnellement à la quantité de lumière reçue par cet élément. Ces charges sont accumulées dans les éléments photosensibles pendant une phase dite d'accumulation, puis sont transférées dans un registre à transfert de charges, appelé registre de lecture, pendant une phase dite de lecture. Les charges accumulées par une rangée d'éléments photosensibles sont transférées en parallèle dans le registre de lecture, puis sont restituées séquentiellement, le registre de lecture ayant pour rôle de décaler le paquet de charges correspondant à chaque élément photosensible, vers une capacité de conversion ayant pour rôle de fournir une tension électrique proportionnelle à la quantité de charges dans chaque paquet. Cette tension est ensuite amplifiée par un préamplificateur dont la sortie constitue la sortie du capteur d'images.

Il est très fréquent qu'une image comporte des zones sur-éclairées, parce qu'elles représentent une source de lumière ou un objet réfléchissant une source de lumière, situé dans le champ de prise de vue du capteur d'images. La quantité de charges libérées dans les éléments photosensibles sur-éclairés peut saturer ces éléments et le registre de lecture. Les charges excédentaires peuvent déborder dans les éléments photosensibles voisins et les cellules voisines du registre de lecture. Ce phénomène se traduit par un halo ou une traînée lumineuse au voisinage des points sur-éclairés, appelé éblouissement, dans l'image restituée à partir du signal fourni par le capteur d'images.

Il n'est pas possible d'éviter un suréclairement de certains éléments photosensibles, sans réduire exagérément l'éclairement de l'ensemble du capteur d'images. Pour éviter le phénomène d'éblouissement d'un capteur d'images, de nombreux dispositifs, appelés dispositifs anti-éblouissement, ont été conçus. Un premier type de dispositif connu comporte un drain anti-éblouissement voisin de chaque élément photosensible, et séparé de celui-ci par une barrière de potentiel dont la valeur algébrique est supérieure à celle de la barrière de potentiel séparant l'élément photosensible du registre de lecture pendant la phase d'accumulation. Ainsi le drain évacue les charges excédentaires qui pourraient déborder de cet élément photosensible pendant la phase d'accumulation, en cas de suréclairement.

Un second type connu de dispositif anti-éblouissement comporte un drain anti-éblouissement situé en profondeur sous chaque élément photosensible. Ce drain est fabriqué selon la technique dite à couche enterrée ou à caisson. Le principe de fonctionnement est identique à celui du dispositif du premier type.

Les drains anti-éblouissement sont parfaitement efficaces pendant la durée d'accumulation des charges mais sont totalement inopérants pendant la durée du transfert des charges dans le registre de lecture, car la barrière de potentiel délimitant chaque cellule du registre de lecture a un niveau inférieur à celui de la barrière de potentiel séparant l'élément photosensible de son drain anti-éblouissement. La phase de lecture a une durée beaucoup plus courte que la phase d'accumulation, néanmoins un fort suréclairement peut provoquer la saturation de cellules du registre de lecture. L'efficacité de ces deux types de dispositif anti-éblouissement est donc limitée aux suréclairements modérés. Il n'est pas possible de réduire simplement la durée de la phase de lecture pour combattre ce phénomène d'éblouissement, car une réduction de la durée de la phase de lecture peut provoquer une augmentation du phénomène de rémanence se traduisant par une dégradation de la fonction de transfert de modulation verticale du capteur d'images.

Un autre dispositif anti-éblouissement est connu par le document Patent Abstract of Japan, vol. 6, n° 87 (E-108) [965], 25 Mai 1982, JP-A-57-21878 (Nippon Kenki K.K.). Ce document décrit un dispositif photosensible ayant une matrice photosensible du type a transfert de ligne. Des charges excédentaires sont éliminées avant chaque chargement dans un registre de lecture. Mais là encore, les charges excédentaires éliminées sont engendrées durant la phase d'accumulation, et non pendant le transfert des charges.

La demande de brevet français n° FR-A-2 538 200 décrit un capteur d'images comportant un second type de dispositif anti-éblouissement, dans lequel la durée de la phase de lecture est réduite sans provoquer de dégradations de la fonction de transfert de modulation verticale par l'utilisation d'une charge dite d'entraînement, qui est introduite dans le registre de lecture par un étage dit d'injection. La charge d'entraînement est transférée dans les cellules du registre de lecture pendant la durée d'accumulation des charges libérées par la lumière et l'évacuation des charges accumulées précédemment, puis est transférée dans l'élément photosensible juste avant la lecture des charges accumulées dans cet élément. Les charges libérées par la lumière et la charge d'entraînement sont ensuite transférées ensemble, de l'élément photosensible vers la cellule du registre de lecture, pendant la phase de lecture dont la durée est réduite.

La charge d'entraînement a une valeur constante qui, en principe ne perturbe pas la valeur du signal vidéo fourni par le capteur d'images. Cependant la charge d'entraînement ajoute un bruit dit d'injection, et un bruit, dit de transfert, à ce signal vidéo. L'utilisation d'un registre de lecture à transfert en volume, plutôt qu'à transfert en surface permet de ne pas trop augmenter le bruit du capteur d'images, cependant ce bruit est supérieur à celui d'un capteur d'images classique. D'autre part, ce dispositif repousse la limite des suréclairements acceptables sans éblouissement mais pas suffisamment.

Le but de l'invention est de remédier à ces deux inconvénients par des moyens simples.

L'objet de l'invention est un dispositif anti-éblouissement comportant des drains anti-éblouissement classiques pour évacuer les charges excédentaires libérées pendant la phase d'accumulation ; et comportant en outre un registre auxiliaire couplé à chaque registre de lecture, pour recueillir, transporter, et finalement évacuer dans un drain, les charges excédentaires libérées pendant la durée du transfert des charges entre un ensemble d'éléments photosensibles et le registre de lecture.

Selon l'invention, un dispositif anti-éblouissement pour capteur d'images à transfert de charges, ce capteur comportant :

- au moins un ensemble d'éléments photosensibles où des charges sont libérées par de la lumière ;
- au moins un registre de lecture à transfert de charges, couplé à chaque ensemble d'éléments photosensibles, les charges libérées dans chaque ensemble d'éléments photosensibles étant transférées dans ce registre puis étant décalées vers une sortie série de ce registre ;
  le dispositif anti-éblouissement comportant
- des premiers drains anti-éblouissement couplés respectivement à chaque élément photosensible pour drainer des charges excédentaires libérées pendant une phase d'accumulation des charges dans les éléments photosensibles ;
  et étant caractérisé en ce qu'il comporte en outre un registre auxiliaire couplé à chaque registre de lecture et semblable à celui-ci, et un second drain couplé à chaque registre auxiliaire pour recueillir des charges excédentaires libérées par la lumière pendant la durée du transfert des charges des éléments photosensibles au registre de lecture correspondant, puis décaler et évacuer ces charges excédentaires vers l'un des seconds drains.

L'invention sera mieux comprise et d'autres détails apparaîtront à l'aide de la description ci-dessous et des figures l'accompagnant :

- la figure 1 représente le schéma synoptique d'un exemple de réalisation d'un capteur d'images linéaire de type connu comportant un drain anti-éblouissement connu couplé à chaque élément photosensible ;
- la figure 2 illustre le fonctionnement de cet exemple de réalisation ;
- la figure 3 représente le schéma synoptique d'un exemple de réalisation d'un dispositif anti-éblouissement selon l'invention associé à ce capteur d'images linéaire ;
- la figure 4a représente une coupe schématique de cet exemple de réalisation ;
- les figures 4b, 4c et 4d illustrent le fonctionnement de cet exemple de réalisation pendant la phase d'accumulation et pendant la phase de lecture ;
- la figure 5a représente une coupe schématique d'une variante de cet exemple de réalisation ;
- les figures 5b et 5c illustrent le fonctionnement de cette variante de réalisation, pendant la phase d'accumulation et pendant la phase de lecture ;
- la figure 6 représente le schéma synoptique d'un exemple de réalisation d'un capteur d'images matriciel de type connu ;
- la figure 7 représente un exemple de réalisation du dispositif anti-éblouissement, selon l'invention, associé à ce capteur d'images matriciel.

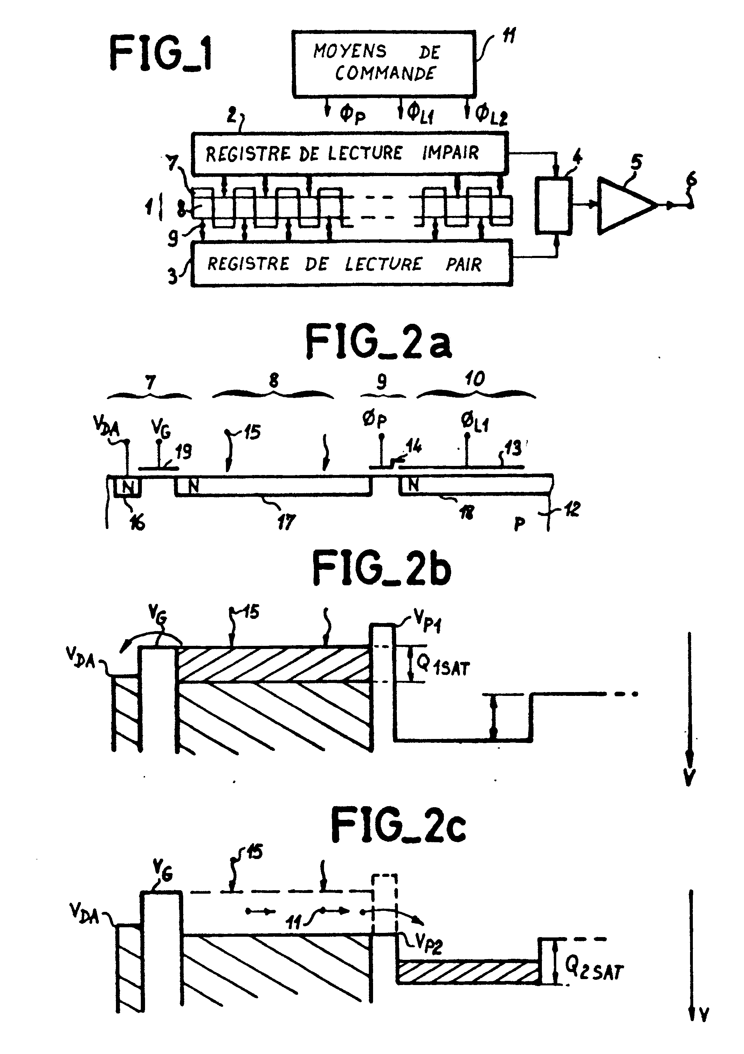

La figure 1 représente le schéma synoptique d'un exemple de réalisation d'un capteur d'images linéaire, de type connu, comportant un drain anti-éblouissement pour chaque élément photosensible. Ce capteur comporte : une rangée 1 d'éléments photosensibles 8 ; un registre de lecture dit impair, 2, et un registre de lecture dit pair, 3 ; une capacité de conversion, 4 ; un préamplificateur 5 ; une borne de sortie 6 fournissant un signal vidéo ; et des moyens de commande 11.

Chaque élément photosensible 8 est associé à un drain anti-éblouissement 7 et est relié, par une porte 9, à une cellule de l'un des registres de lecture 3 ou 2. Les éléments photosensibles 8 ayant un rang pair sont reliés à une cellule du registre 3 et les éléments photosensibles 8 ayant un rang impair sont reliés respectivement à une cellule du registre de lecture impair 2. Les registres 2 et 3 possèdent chacun une sortie série reliée à la capacité de conversion 4. Celle-ci fournit une tension à une entrée du préamplificateur 5, proportionnelle à la quantité de charges fournie par la sortie de l'un des registres 2 ou 3. Les portes 9 et les cellules des registres 2 et 3 sont commandées par des réseaux d'électrodes, non représentés, reliés aux moyens de commande 11 pour recevoir des signaux de commande $\phi_{L1}$, $\phi_{L2}$ et $\phi_P$.

Pendant la phase d'accumulation des charges qui, en l'occurrence, sont des électrons, les portes 9 sont fermées. Pendant la phase de lecture, les portes 9 sont ouvertes simultanément par le signal de commande $\phi_P$ pour transférer les charges contenues dans les éléments photosensibles 8, vers les cellules des registres 2 et 3. Puis ces portes 9 sont refermées et les registres sont utilisés comme des registres à décalage pour transférer ces charges vers la capacité 4. Deux signaux de commande $\phi_{L1}$ et $\phi_{L2}$ sont appliquées à des électrodes pour décaler les charges contenues dans le registre 2 et les charges contenues dans le registre 3.

La figure 2a représente une coupe schématique transversale de cet exemple de réalisation, montrant un élément photosensible 8, et le drain anti-éblouissement 7, la porte 9, et une cellule 10 du registre de lecture 3, associés à l'élément photosensible 8. Sur cette figure, l'isolant situé sous les électrodes n'est pas représenté pour plus de clarté. Il est constitué de silice. L'élément photosensible 8 reçoit des photons 15 et est constitué par une zone 17 de dopant N implanté dans un substrat 12 en silicium de type P. Le drain anti-éblouissement 7 est constitué d'un transistor M.O.S. comportant une grille 19, un drain 16 formé par l'implantation d'un dopant N dans le substrat, et d'une source formée par l'extrémité de la zone 17 de dopant N de l'élément photosensible 8. La grille 19 est portée à un potentiel constant $V_G$ et le drain 16 est porté à un potentiel constant $V_{DA}$ supérieur au potentiel du canal existant sous la grille 19.

La porte 9 est constituée par une grille 14 surmontant une zone de substrat 12 qui est sans implantation, dans cet exemple. Dans d'autres exemples de réalisation, cette zone du substrat 12 peut comporter une implantation N sans nuire au fonctionnement. La grille 14 est commandée par le signal $\emptyset_P$ pouvant prendre deux valeurs de potentiel : $V_{P1}$ ou $V_{P2}$. La cellule 10 est constituée par une zone 18 de dopant N implanté dans le substrat 12, et par une électrode 13 surmontant la zone 18 et commandée par le signal $\emptyset_{L1}$ pouvant prendre deux valeurs de potentiel. Chaque cellule des registres de lecture 2 et 3 est séparée des 2 cellules voisines par des portes non représentées, analogues à la porte 9 et commandées par le signal $\emptyset_{L2}$ qui peut prendre deux valeurs de potentiel. Le potentiel de $\emptyset_{L1}$ et le potentiel de $\emptyset_{L2}$ changent avec un déphasage déterminé, pour faire fonctionner les registres 2 et 3 comme des registres à décalage, après le transfert des charges dans ces registres.

La figure 2b représente un diagramme des potentiels dans l'espace de la coupe représentée sur la figure 2a, pendant la phase d'accumulation des charges. Les potentiels sont repérés par rapport à un axe vertical orienté de haut en bas. Les charges libérées par les photons 15 s'accumulent dans le canal délimité par la barrière de potentiel $V_G$ créée par l'électrode 19 et la barrière de potentiel $V_{P1}$ créée par l'électrode 14. Ce canal peut recueillir au maximum une quantité de charges $Q_{1SAT}$. S'il y a suréclairement, les charges débordent de ce canal en passant par dessus la barrière $V_G$ dont la valeur algébrique est légèrement supérieure à $V_{P1}$. Ainsi les charges débordent vers le drain 16 sans atteindre le niveau $V_{P1}$ où elles pourraient déborder vers le registre de lecture ou vers les éléments photosensibles voisins, dégradant ainsi les informations contenues dans le registre de lecture.

La figure 2c représente un diagramme des potentiel dans l'espace de la coupe représentée sur la figure 2a, pendant la phase de lecture. La barrière de potentiel séparant l'élément photosensible 8 de la cellule 10 est abaissée à un potentiel $V_{P2}$ dont la valeur algébrique est supérieure à $V_{P1}$. Les charges accumulées s'écoulent donc vers la cellule 10 mais elles sont accompagnées d'un supplément de charge 11 créé par l'éclairement pendant la phase de lecture. Chaque cellule 10 est prévue pour recueillir au maximum une charge $Q_{2SAT}$ qui est plus grande que la charge maximale $Q_{1SAT}$ accumulable dans un élément photosensible 8, cependant la quantité de charges supplémentaire libérée pendant la phase de lecture peut être supérieure à la différence entre $Q_{2SAT}$ et $Q_{1SAT}$.

Dans ce cas, les charges débordent de la cellule 10 vers les cellules voisines, il y a éblouissement. Le drain anti-éblouissement 7 joue parfaitement son rôle pendant la phase d'accumulation mais est tout à fait inopérant pendant la phase de lecture.

Par exemple, si une cellule 10 du registre de lecture 3 peut accueillir une charge $Q_{2SAT}$ 1,25 fois supérieure à la charge $Q_{1SAT}$, et si la durée d'accumulation est de 3 millisecondes et la durée de lecture de 10 microsecondes, alors un suréclairement égal à 75 fois l'éclairement de saturation de l'élément photosensible provoque la saturation de la cellule 10, et par conséquent crée un éblouissement.

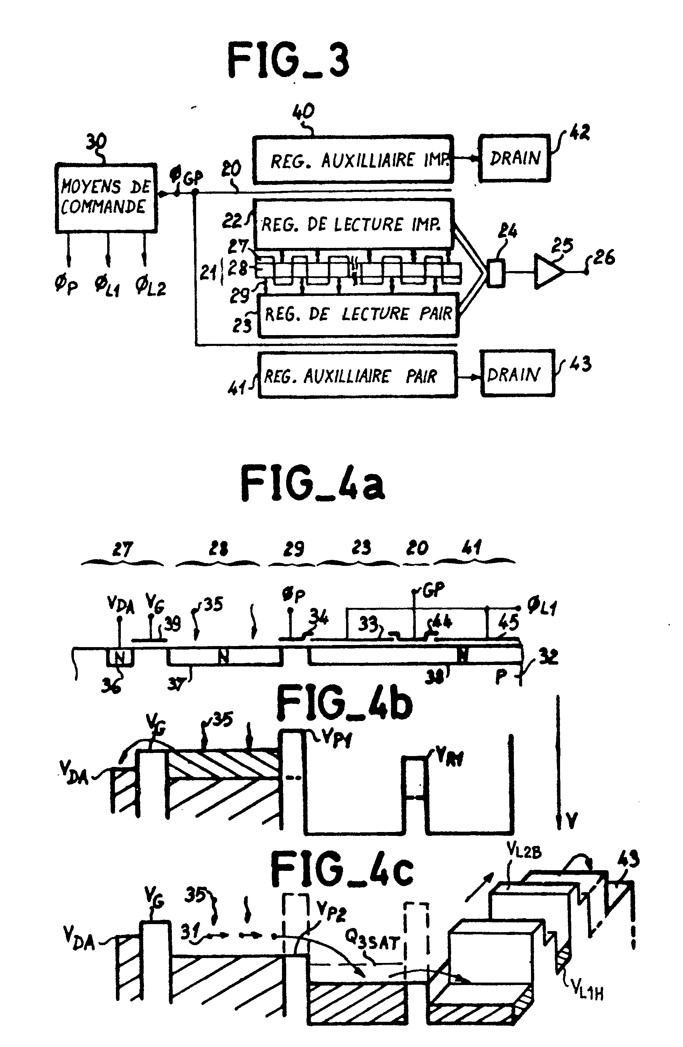

La figure 3 représente le schéma synoptique d'un exemple de réalisation d'un capteur d'images linéaire de type connu associé au dispositif anti-éblouissement selon l'invention. Le capteur d'images linéaire comporte une rangée, 21, d'éléments photosensibles 28. Chaque élément photosensible 28 est associé à un drain anti-éblouissement 27 et à une cellule d'un registre de lecture 22 ou 23, par l'intermédiaire d'une porte 29. Les cellules 28 de rang pair sont associées à une cellule d'un registre de lecture pair, 23. Les éléments photosensibles 28 de rang impair sont associés à une cellule d'un registre de lecture impair, 22. Les registres de lecture 22 et 23 possèdent chacun une sortie série reliée à une capacité de conversion 24. Cette dernière a une sortie reliée à une entrée d'un préamplificateur 25 fournissant un signal vidéo à une borne de sortie 26 du capteur d'images.

Un réseau d'électrodes, non représenté, commande les portes 29 et les registres de lecture 22 et 23. Des moyens de commande 30 fournissent à ce réseau des signaux de commande $\phi_P$, $\phi_{L1}$ et $\phi_{L2}$ identiques à ceux de l'exemple de réalisation décrit précédemment. Le fonctionnement des éléments 21 à 29 est tout à fait identique au fonctionnement des éléments 1 à 9 de l'exemple de réalisation représenté sur la figure 1 et décrit précédemment. L'exemple de réalisation représenté sur la figure 3 comporte en outre un registre auxiliaire impair, 40, associé au registre de lecture impair 22 ; un registre auxiliaire pair, 41, associé au registre de lecture pair 23 ; un drain 42 relié à une sortie série du registre 40 et un drain 43 relié à une sortie série du registre 41 ; et des portes non représentées sur la figure 3, reliant respectivement les cellules des registres de lecture 22 et 23 aux cellules des registres auxiliaires 40 et 41. Ces portes sont commandées par un réseau d'électrodes 20 recevant un signal de commande $\phi_{GP}$. Les registres auxiliaires 40 et 41 sont commandés par les mêmes signaux, $\phi_{L1}$ et $\phi_{L2}$, que les registres de lecture 22 et 23. Les moyens de commande 30, de réalisation classique, fournissent en outre le signal de commande $\phi_{GP}$ qui est décrit dans la suite.

La figure 4a représente une coupe schématique transversale de cet exemple de réalisation. Les isolants situés sous les électrodes ne sont pas représentés pour plus de clarté. Ils sont constitués de silice. Cette figure montre : un élément photosensible 28 associé à un transistor M.O.S. anti-éblouissement, 27 ; une porte 29 ; une cellule du registre de lecture pair, 23 ; une cellule du registre auxiliaire pair, 41 ; et une électrode 44 appartenant au réseau d'électrodes 20 et constituant une porte de liaison entre ces deux cellules.

L'élément photosensible 28 est constitué d'une zone 37 de dopant N dans un substrat 32 de silicium de type P. Le transistor anti-éblouissement 27 est constitué d'une électrode 39 portée à un potentiel constant $V_G$ et d'un drain formé d'une zone 36 de dopant N implanté dans le susbtrat 32, et porté à un potentiel constant $V_{DA}$ dont la valeur algébrique est supérieure à $V_G$. La porte 29 est constituée par une électrode 34 surmontant une zone du substrat 32, ne comportant pas d'implantation.

Le registre de lecture 23 et le registre auxiliaire 41 comportent chacun un canal de transfert des charges constitué par une même zone 38 de dopant N implanté dans le substrat 32. Ces deux canaux sont séparés par une barrière de potentiel ayant un niveau variable selon la valeur du signal de commande $\phi_{GP}$ appliqué à l'électrode 44. Une électrode 33 surmonte la cellule du registre de lecture 23 et une électrode 45 surmonte la cellule du registre auxiliaire 41. Toutes deux reçoivent le signal de commande $\phi_{L1}$ dans cet exemple. Les cellules voisines, non représentées sur la figure 4a, dans le registre 23 et dans le registre 41, sont surmontées d'électrodes analogues aux électrodes 33 et 45, et recevant aussi le signal de commande $\phi_{L1}$. Les cellules du registre 23 sont séparées de leurs voisines par des portes, non représentées, constituées par des électrodes recevant le signal de commande $\phi_{L2}$ déphasé par rapport au signal $\phi_{L1}$, pendant la phase de transfert des charges d'une cellule à une autre. Il en est de même pour les cellules du registre 41.

La figure 4d représente un diagramme temporel des signaux $\phi_{L1}$, $\phi_{L2}$, $\phi_P$, $\phi_{GP}$, pendant la phase de transfert des charges dans le registre et la phase de décalage des charges dans le registre de lecture et le registre auxiliaire. Les potentiels sont repérés par rapport à un axe vertical orienté de haut en bas comme sur les figures précédentes.

Il est à remarquer que, dans cet exemple de réalisation, le registre auxiliaire 41 est analogue au registre de lecture 23. Ces deux registres peuvent être fabriqués simultanément parce que leurs canaux de transfert sont constitués par la même zone 38 où est implanté un matériau de type N et parce que les électrodes 34 et 45 peuvent être déposées simultanément. Par rapport à la fabrication du capteur d'images classique, il est seulement nécessaire de compléter les moyens de commande 30 pour produire le signal de commande GP, décrit plus loin, et de rajouter un niveau supplémentaire de silicium polycristalin, pour réaliser l'électrode 44 des portes de transfert entre les cellules du registre 23 et du registre 41. Il en est de même pour les registres 22 et 40.

La figure 4b représente un diagramme des potentiels dans l'espace de cette coupe, pendant la phase d'accumulation des charges dans le capteur d'images. Comme dans le capteur classique, la lumière 35 libère des charges qui s'accumulent dans l'élément photosensible 28. Si l'éclairement est très important et sature l'élément photosensible, des charges débordent en passant par dessus la barrière de potentiel $V_G$ créée par l'électrode 39 et sont attirées par le potentiel $V_{DA}$ du drain 36. Elles ne peuvent pas déborder du côté du registre de lecture 23 car l'électrode 34 de la porte de passage reçoit un signal $\phi_P$ ayant un potentiel $V_{P1}$ dont la valeur algébrique est inférieure à $V_G$. Le signal de commande GP a un potentiel $V_{R1}$ proche du potentiel $V_{P1}$ pendant la phase d'accumulation.

Ces deux potentiels peuvent être nuls.

La figure 4c représente un diagramme des potentiels dans l'espace de la coupe représentée sur la figure 3, pendant la phase de lecture. Le signal de commande $\phi_P$ prend une valeur de potentiel $V_{P2}$ supérieure à $V_{P1}$, et supérieure à $V_G$ ,ce qui permet aux charges accumulées dans l'élément photosensible 28 de passer dans la cellule du registre 23. Pendant la durée de la lecture de l'élément photosensible 28 la lumière 35 continue à libérer des charges 31 qui s'additionnent aux charges accumulées pendant la phase d'accumulation. Si le suréclairement est très important la charge totale transférée dans la cellule du registre 23 peut être supérieure à la quantité $Q_{3SAT}$ nécessaire pour saturer cette cellule et pourrait provoquer un débordement des charges vers les cellules voisines. Mais pendant le transfert des charges vers le registre 23 le signal de commande GP prend une valeur de potentiel $V_{R2}$ supérieure à $V_{R1}$ et supérieure à la valeur algébrique du potentiel correspondant au stockage d'une charge $Q_{3SAT}$ dans la cellule du registre 23. Par conséquent, une partie des charges tendant à saturer la cellule du registre 23 passent par dessus la barrière de potentiel de niveau $V_{R2}$ et va dans la cellule du registre 41.

Comme représenté sur la figure 4d, pendant la phase de transfert des charges dans les registres de lecture, le signal $\phi_{L1}$ reste à un niveau constant égal à sa plus grande valeur de potentiel, et le signal $\phi_{L2}$ reste à un niveau constant égal à sa plus faible valeur de potentiel, pour isoler les cellules du registre de lecture et isoler les cellules du registre auxiliaire en attirant les charges sous les électrodes 33 et 45. Le signal $\phi_P$ prend sa valeur maximale de potentiel, $V_{P2}$, puis, peu après, le signal GP prend sa valeur maximale de potentiel $V_{R2}$ . Ils gardent ces valeurs maximales pendant une durée légèrement inférieure à la durée pendant laquelle $\phi_{L1}$ et $\phi_{L2}$ restent à un niveau constant. Juste avant la phase de décalage des charges, le signal $\phi_P$ reprend sa valeur $V_{P1}$ pour isoler l'élément photosensible 28 du registre 23 et, peu après, le signal de commande GP reprend la valeur $V_{R1}$ pour isoler les registres 23 et 41. Ensuite les signaux de commande $\phi_{L1}$ et $\phi_{L2}$ changent de valeurs alternativement pour décaler les charges à l'intérieur des registres 23 et 24. Les charges contenues alors dans le registre 23 sont décalées de cellules en cellules jusqu'à atteindre la capacité de conversion 24, alors que les charges contenues dans les cellules du registre auxiliaire 41 sont décalées jusqu'au drain 43 où elles sont évacuées. Les signaux $\phi_{L1}$ , $\phi_{L2}$ , $\phi_P$ sont les mêmes que pour un capteur d'images classique à signaux de commande biphasés. Il est à la portée de l'homme de l'Art de modifier les moyens de commande classiques pour fournir en outre le signal GP.

Le suréclairement maximal admissible par ce dispositif est d'autant plus grand que la largeur des registres auxiliaires 40 et 41 est plus grande. Un éblouissement du dispositif capteur d'images se produit lorsque la quantité de charges fournie par l'élément photosensible 28 atteint une valeur égale à la somme des quantités de charges correspondant respectivement à la saturation d'une cellule du registre 23 et à la saturation d'une cellule du registre 41.

Par exemple, si la quantité de charges correspondant à la saturation du registre auxiliaire 41 est égale au double de la quantité de charges $Q_{3SAT}$ correspondant à la saturation du registre 23, c'est-à-dire si la largeur du registre 41 est égale au double de la largeur du registre 23, et si $Q_{3SAT}$ est égale à 1,25 fois la quantité de charges $Q_{1SAT}$ correspondant à la saturation d'un élément photosensible, alors un calcul montre que le suréclairement peut atteindre 825 fois l'éclairement de saturation de l'élément photosensible 28, sans éblouissement pour une durée d'accumulation de 3ms et une durée de lecture de 10 microsecondes.

D'une façon générale, le suréclairement supportable N est donné par la formule :

$$N = (\frac{Q_{2SAT}}{Q_{1SAT}} - 1).\frac{T_i}{T_L}$$

où $Q_{2SAT}$ est la quantité de charges correspondant à la saturation de l'élément photosensible, $T_i$ est la durée d'accumulation, et $T_L$ la durée de la lecture.

Le dispositif anti-éblouissement selon l'invention permet donc à un capteur d'images de supporter sans éblouissement des suréclairements très supérieurs à ceux supportables par un capteur d'images comportant seulement un drain anti-éblouissement connu, et sans ajouter de bruit au signal vidéo.

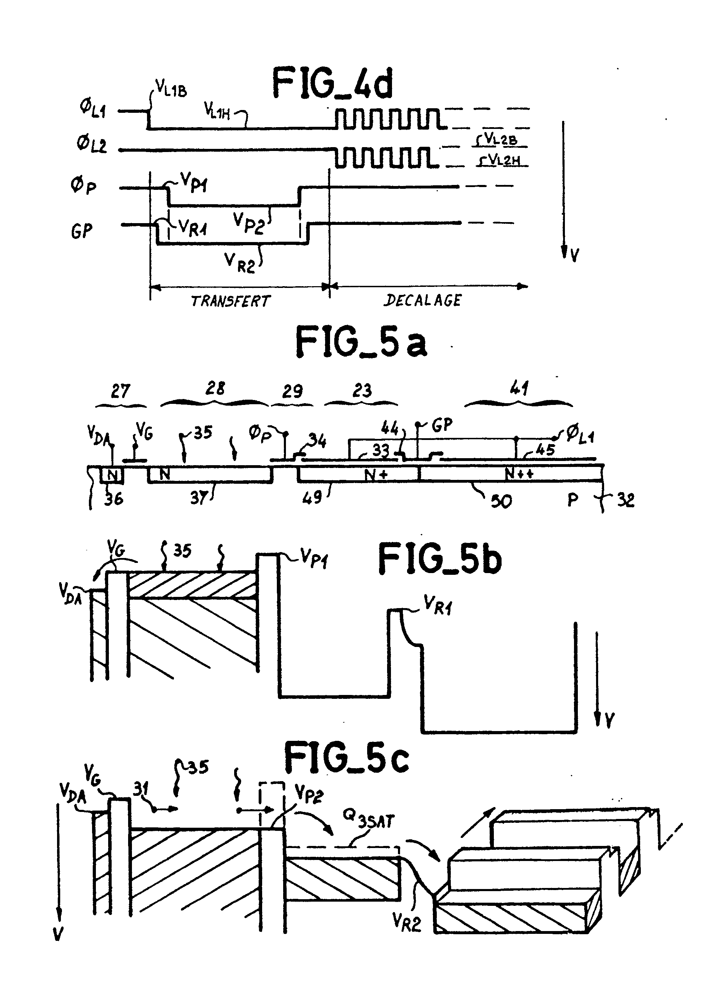

La figure 5a représente une coupe schématique d'un second mode de réalisation d'un capteur d'images comportant un dispositif anti-éblouissement selon l'invention. Ce second mode de réalisation diffère du premier par la structure des canaux des registres de lecture et des registres auxiliaires. Les autres éléments sont identiques et portent, sur la figure 5a, les mêmes références que sur la figure 4a. Les registres de lecture 22 et 23 comportent chacun un canal de transfert constitué d'une zone 49 où est implanté un matériau de type $N^+$ dans le substrat 32 en silicium de type P. Les registres auxiliaires 40 et 41 comportent chacun un canal de transfert formé d'une zone 50 où est implanté un matériau du type $N^{++}$ dans le substrat 32. Chaque cellule du registre de lecture 23 est surmontée d'une électrode 33 et chaque cellule du registre 41 est surmontée d'une électrode 45 reliée à l'électrode 33 de la cellule homologue du registre 23, comme dans le premier mode de réalisation. Chaque cellule du registre 23 est reliée à une cellule du registre 41 par une porte constituée d'une électrode 44 commandée par le signal de commande GP et cette électrode 44 est située au-dessus de la frontière commune aux zones 49 et 50. Les signaux de commande sont les mêmes que dans le premier mode de réalisation.

La figure 5b représente un diagramme des potentiels dans l'espace de la coupe représentée sur la figure 5a, pendant la phase d'accumulation des charges dans l'élément photosensible 28. La différence de dopage entre le canal de transfert du registre 41 et le canal de transfert du registre 23 a pour conséquence que le canal du registre 41 est à un potentiel dont la valeur algébrique est nettement supérieure à celle du canal du registre 23. Pendant la phase d'accumulation des charges dans l'élément photosensible 28, le fonctionnement est inchangé par rapport au premier mode de réalisation et par rapport au fonctionnement du capteur d'images classique comportant un transistor anti-éblouissement.

La figure 5c représente un diagramme des potentiels dans l'espace de la coupe représentée sur la figure 5a, pendant la phase de lecture des charges accumulées dans l'élément photosensible 28. Le signal de commande $\phi_P$ prenant une valeur de potentiel $V_{P2}$ supérieure à $V_{P1}$, les charges accumulées sont transférées vers le registre 23 ainsi que des charges 31 libérées par la lumière 35 pendant cette phase de lecture. Le signal de commande GP a une valeur de potentiel $V_{R2}$ supérieure à la valeur de potentiel correspondant à la charge $Q_{3SAT}$ pour laquelle la cellule du registre 23 est saturée et pour laquelle les charges pourraient déborder vers les cellules voisines.

Les charges excédentaires, en cas de fort éclairement, franchissent donc la barrière de potentiel de niveau $V_{R2}$ et descendent dans la cellule du registre 41. Puis le signal de commande GP reprend la valeur de potentiel $V_{R1}$ pour isoler de nouveau le registre 23 et le registre 41 après que le signal $\phi_P$ ait fermé la porte 29, comme précédemment. Puis les charges sont décalées d'une cellule à une autre dans le registre 23 jusqu'à la capacité de conversion 24 et les charges excédentaires, situées dans les cellules du registre 41, sont décalées d'une cellule à une autre jusqu'au drain 43.

A cause de la différence de potentiel entre le canal de transfert du registre 41 et le canal de transfert du registre 23, un excédent de charges ne peut que descendre les lignes de potentiel du registre 23 au registre 41 et ne peut jamais remonter ces lignes et provoquer un débordement d'une cellule du registre 23 à une cellule voisine, quelle que soit la valeur du suréclairement.

Ce second exemple de réalisation du dispositif anti-éblouissement selon l'invention repousse donc encore plus loin, de façon pratiquement définitive la valeur maximale des suréclairements possibles sans éblouissement. Par rapport au premier exemple, il nécessite une étape de fabrication en plus, pour implanter la zone 50 de dopant $N^{++}$.

Le registre auxiliaire associé à chaque registre de lecture pour constituer un dispositif anti-éblouissement, selon l'invention, a un encombrement non négligeable qui est sans inconvénient pour un capteur d'images du type linéaire mais qui est plus difficilement compatible avec les capteurs d'images du type matriciel. Cependant il existe des capteurs d'images de type matriciel dans lesquels il est tout à fait possible d'incorporer un dispositif anti-éblouissement selon l'invention. C'est notamment le cas pour un dispositif appelé CHARGE SWEEP DEVICE décrit dans la revue MITSUBISHI ELECTRONIC ADVANCE page 20, décembre 1985.

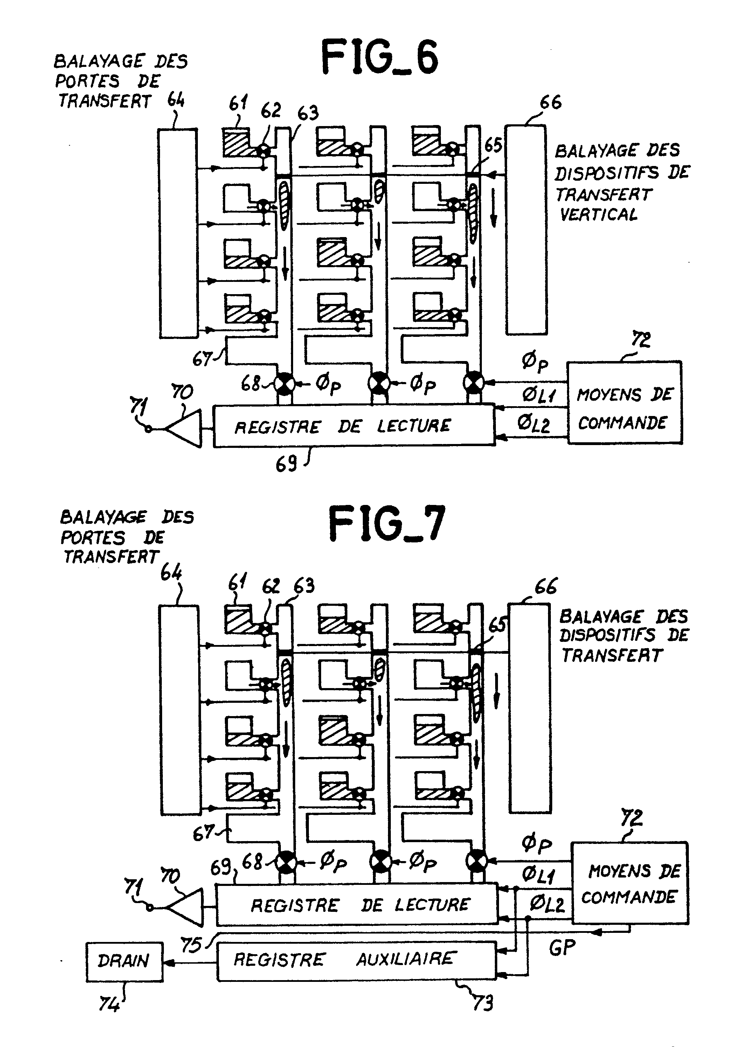

Un schéma synoptique de ce capteur d'images de type matriciel est représenté sur la figure 6. Il comporte une matrice de photodiodes 61, chaque photodiode étant reliée par une porte 62 à un dispositif de transfert vertical 63. Chaque dispositif de transfert vertical 63 comporte à une extrémité un dispositif 67 de stockage et une porte 68. Dans ce dispositif, les lignes de la matrice sont sélectionnées et lues successivement et non pas simultanément. Pendant une période correspondant à une ligne, les portes 62 d'une seule ligne sont ouvertes sous la commande d'un dispositif 64 de balayage des portes de transfert, et chaque dispositif de transfert vertical 63 transporte les charges fournies par une seule photodiode 61, sous la commande d'un dispositif 66 de balayage des dispositifs de transfert qui réalise le déplacement d'une barrière de potentiel 65 dans chaque dispositif 63 de transfert vertical.

La longueur entière d'un dispositif de transfert vertical 63 est disponible pour transporter les charges d'une seule photodiode 61, par conséquent la capacité de transfert de ce dispositif de transfert vertical 63 est importante, même s'il est réalisé avec une largeur de canal très faible. Les charges transportées par chaque dispositif 63 sont accumulées dans un dispositif de stockage 67 puis sont transmises à une cellule du registre de lecture 69. Ce dernier est un registre à transfert de charges classique, recueillant les charges correspondant à une ligne d'image et les transmettant à un préamplificateur 70 qui fournit un signal vidéo à une borne de sortie 71. Des moyens de commande 72 fournissent des signaux de commande déphasés,

$\phi_{L1}$ et $\phi_{L2}$, pour commander le décalage des charges dans le registre de lecture 69, et un signal de commande $\phi_P$ pour commander les portes 68. Celles-ci sont ouvertes pendant la durée du transfert dans les dispositifs de transfert vertical 63.

La figure 7 représente le schéma synoptique d'un exemple de réalisation de ce type de capteur d'images associé à un dispositif anti-éblouissement, selon l'invention. Cet exemple de réalisation comporte, en plus des éléments décrits ci-dessus, un registre auxiliaire 73 couplé au registre de lecture 69 par des portes, non représentées, commandées par une électrode commune 75 recevant un signal de commande GP fourni par une sortie supplémentaire des moyens de commande 72. Les signaux $\phi_p$, $\phi_{L1}$, $\phi_{L2}$, et GP sont analogues à ceux décrits précédemment. Une sortie série du registre auxiliaire 73 est reliée à un drain 74 pour évacuer les charges excédentaires transférées du registre de lecture 69 au registre auxiliaire 73 sous l'action du signal GP, puis décalées vers la sortie série sous l'action des signaux de commande $\phi_{L1}$ et $\phi_{L2}$ qui sont les mêmes que pour la commande du registre de lecture 69. Comme pour les exemples de réalisation décrits précédemment, le registre de lecture 69 et le registre auxiliaire 73 peuvent être réalisés au moyen d'une même implantation de dopant N ou bien au moyen de deux implantations différentes, respectivement de dopant $N^+$ ou de dopant $N^{++}$.

L'invention ne se limite pas aux exemples décrits ci-dessus, elle peut être appliquée à des capteurs d'images ayant des registres de lecture à transfert de charge monophasé, biphasé, triphasé, ou quadriphasé. Elle peut être appliquée aussi bien à des registres ayant un canal à enrichissement ou un canal à appauvrissement.

Elle est applicable à tous les capteurs d'images ayant au moins un registre de lecture à transfert de charges, notamment dans le domaine des caméras de télévision.

**Revendications**

1. Dispositif anti-éblouissement pour capteur d'images à transfert de charges ce capteur comportant :
   - au moins un ensemble (21) d'éléments photosensibles (28) où des charges sont libérées par de la lumière (35) ;
   - au moins un registre de lecture (22, 23) à transfert de charges, couplé à chaque ensemble (21) d'éléments photosensibles (28) les charges libérées dans chaque ensemble d'éléments photosensibles étant transférées dans ce registre (22, 23) puis étant décalées vers une sortie série de ce registre (22, 23) ;

le dispositif anti-éblouissement comportant
   - des premiers drains anti-éblouissement (27) couplés respectivement à chaque élément photosensible (28) pour drainer des charges excédentaires libérées pendant une phase d'accumulation des charges dans les éléments photosensibles (28) ;

et étant caractérisé en ce qu'il comporte en outre un registre auxiliaire (40, 41) couplé à chaque registre de lecture (22, 23) et semblable à celui-ci, et un second drain (42, 43) couplé à chaque registre auxiliaire (40, 41) pour recueillir des charges excédentaires (31) libérées par la lumière (35) pendant la durée du transfert des charges des éléments photosensibles (28) au registre de lecture (22, 23) correspondant, puis décaler et évacuer ces charges excédentaires vers l'un des seconds drains (42, 43).

2. Dispositif selon la revendication 1 caractérisé en ce qu'il comprend une porte (20) telle que chaque cellule d'un registre de lecture (22, 23) est couplée à une cellule d'un registre auxiliaire (29, 30) par cette porte (20), laquelle porte crée une barrière de potentiel basse pendant la durée du transfert des charges d'un ensemble (21) d'éléments photosensibles (28) au registre de lecture (22 23) ; et haute pendant la durée du décalage des charges dans le registre de lecture (22, 23) et dans le registre auxiliaire (29, 30).

3. Dispositif selon la revendication 1 caractérisé en ce que chaque registre auxiliaire (40, 41) a un canal constitué par une zone de dopant (38) qui est la même que celle constituant le canal du registre de lecture (22, 23) auquel il est couplé.

4. Dispositif selon la revendication 1 caractérisé en ce que le canal de chaque registre auxiliaire (40, 41) est constitué par une zone de dopant (50) différente de celle (49) constituant le canal du registre de lecture (22, 23) auquel il est couplé de telle sorte que les charges excédentaires recueillies dans chaque registre auxiliaire (40, 41) ne peuvent revenir dans le registre de lecture associé (22, 23).

5. Capteur d'images comportant :
   - au moins un ensemble (21) d'éléments photosensibles (28) où des charges sont libérées par de la lumière (35) ;
   - au moins un registre de lecture (22, 23) à transfert de charges, couplé à chaque ensemble (21) d'éléments photosensibles (28) les charges libérées dans chaque ensemble d'éléments photosensibles étant transférées dans ce registre (22, 23) puis étant décalées vers une sortie série de ce registre (22, 23) ;

caractérisé en ce qu'il comporte en outre un dispositif anti-éblouissement selon l'une des revendications 1 à 4.

**Claims**

1. An anti-blooming device for use with a charge transfer image sensor, said sensor comprising:
   - at least one assembly (21) of photosensitive elements (28) wherein charges are released by light (35);
   - at least a charge transfer read register (22, 23) coupled to each assembly (21) of photosensitive elements (28), the charges released in each assembly of photosensitive elements being transferred into said register (22, 23) and then shifted towards a serial output of said register (22, 23);
   the anti-blooming device comprising
   - first anti-blooming drains (27) coupled respectively to each photosensitive element (28) for draining excess charges released during a phase of accumulation of the charges in the photosensitive elements (28);
   - and being characterized in that it further includes an auxiliary register (40, 41) coupled to each read register (22, 23) and similar to the latter, and a second drain (42, 43) coupled to each auxiliary register (40, 41) for receiving excess charges released by light (35) during the time of transfer of the charges from the photosensitive elements (28) to the corresponding read register (22, 23) and then shifting and evacuating said excess charges towards one of said second drains (42, 43).

2. A device according to claim 1, characterized in that it comprises a gate (20), such that each cell of a read register (22, 23) is coupled to a cell of an auxiliary register (29, 30) via said gate (20), which gate creates a low potential barrier during the time of transfer of the charges from an assembly (21) of photosensitive elements (28) to the read register (22, 23), and a high potential barrier during the shifting of the charges in the read register (22, 23) and in the auxiliary register (29, 30).

3. A device according to claim 1, characterized in that each auxiliary register (40, 41) has a channel constituted of a doped zone (38) which is the same as the one constituting the channel of the read register (22, 23) to which it is coupled.

4. A devise according to claim 1, characterized in that the channel of each auxiliary register (40, 41) is constituted by a doped zone (50) which is different from the zone (49) constituting the channel of the read register (22, 23) to which it is coupled, in such a manner that the excess charges accumulated in each auxiliary register (40, 41) cannot return to the associated read register (22, 23).

5. An image sensor including:
   - at least an assembly (21) of photosensitive elements (28) wherefrm charges are released by light (35);
   - at least one charge transfer read register (22, 23) coupled to each assembly (21) of photosensitive elements (28), the charges released frm each assembly of photosensitive elements being transferred into said register (22, 23) and then shifted towards a serial output of said register (22, 23),
   characterized in that it further includes an anti-blooming device in accordance with one of claims 1 to 4.

**Patentansprüche**

1. Anti-Überhellungseinrichtung für einen Ladungstransfer-Bildsensor, der folgende Komponenten aufweist:
   - mindestens eine Einheit (21) von lichtempfindlichen Elementen (28), bei denen Ladungen durch Licht (35) freigesetzt werden,
   - mindestens ein Ladungstransfer-Leseregister (22, 23), das an jede Einheit (21) lichtempfindlicher Elemente (28) gekoppelt ist, wobei die in jeder Einheit lichtempfindlicher Elemente freigesetzten Ladungen in dieses Register (22, 23) transferiert und dann zu einem Serienausgang des Registers (22, 23) hin verschoben werden,
   wobei die Anti-Überhellungseinrichtung erste Anti-Überhellungsdrains (27) aufweist, die je an ein lichtempfindliche Element gekoppelt sind, um während einer Akkumulationsphase der Ladungen in den lichtempfindlichen Elementen (28) freigesetzte überschüssige Ladungen abzuführen,

dadurch gekennzeichnet, daß die Einrichtung weiter ein Hilfsregister (40, 41), das an jedes Leseregister (22, 23) gekoppelt ist und diesem ähnelt, und ein zweites Drain (42, 43) aufweist, das an jedes Hilfsregister (40, 41) gekoppelt ist, um die durch das Licht (35) freigesetzten überschüssigen Ladungen während der Transferdauer der Ladungen der lichtempfindlichen Elemente (28) an das entsprechende Leseregister (22, 23) aufzunehmen, dann zu verschieben und die überschüssigen Ladungen in Richtung auf einen der zweiten Drains (42, 43) abzuführen.

2. Einrichtung nach Anspruch 1, dadurch gekennzeichnet, daß sie ein Tor (20) aufweist, derart, daß jede Zelle eines Leseregisters (22, 23) über das Tor (20) an eine Zelle eines Hilfsregisters (29, 30) gekoppelt ist, wobei das Tor während der Dauer des Ladungstransfers von einer Einheit (21) lichtempfindlicher Elemente (28) zum Leseregister (22, 23) eine niedrige Potentialbarriere und während der Dauer der Verschiebung der Ladungen in das Leseregister (22, 23) und in das Hilfsregister (29, 30) eine hohe Potentialbarriere erzeugt.

3. Einrichtung nach Anspruch 1, dadurch gekennzeichnet, daß jedes Hilfsregister (40, 41) einen aus einer Dotierzone (38) bestehenden Kanal besitzt, wobei diese Zone dieselbe ist, die den Kanal des Leseregisters (22, 23) bildet, mit dem er gekoppelt ist.

4. Einrichtung nach Anspruch 1, dadurch gekennzeichnet, daß der Kanal jedes Hilfsregisters (40, 41) aus einer Dotierzone (50) besteht, die sich von der den Kanal des Leseregisters (22, 23) bildenden Zonew (49) unterscheidet, mit dem sie gekoppelt ist, derart, daß die in jedem Hilfsregister (40, 41) aufgenommenen Überschußladungen nicht in das zugehörige Leseregister (22, 23) zurückkehren können.

5. Bildsensor mit
   - mindestens einer Einheit (21) von lichtempfindlichen Elementen (28), bei denen Ladungen durch Licht (35) freigesetzt werden,
   - mindestens einem Ladungstransfer-Leseregister (22, 23), das an jede Einheit (21) lichtempfindlicher Elemente (28) gekoppelt ist, wobei die in jeder Einheit lichtempfindlicher Elemente freigesetzten Ladungen in dieses Register (22, 23) transferiert und dann zum Serienausgang des Registers (22, 23) hin verschoben werden,

dadurch gekennzeichnet, daß der Sensor weiter eine Anti-Aufhellungseinrichtung gemäß einem der Ansprüche 1 bis 4 umfaßt.

# FIG_1

MOYENS DE COMMANDE — 11

$\phi_P$  $\phi_{L1}$  $\phi_{L2}$

2 — REGISTRE DE LECTURE IMPAIR

7
1 { 8
9

3 — REGISTRE DE LECTURE PAIR

4  5  6

# FIG_2a

7  8  9  10

$V_{DA}$  $V_G$  19  15  $\phi_P$  14  $\phi_{L1}$  13

N  N  N

16  17  18  P — 12

# FIG_2b

$V_G$  15  $V_{P1}$

$V_{DA}$  $Q_{1SAT}$

V

# FIG_2c

$V_G$  15

$V_{DA}$  11  $V_{P2}$  $Q_{2SAT}$

V

# FIG_3

# FIG_4a

# FIG_4b

# FIG_4c

# FIG_4d

$\phi_{L1}$ $V_{L1B}$ $V_{L1H}$

$\phi_{L2}$ $V_{L2B}$ $V_{L2H}$

$\phi_P$ $V_{P1}$ $V_{P2}$

GP $V_{R1}$ $V_{R2}$

$V$

TRANSFERT          DECALAGE

# FIG_5a

27      28      29      23      41

$V_{DA}$ $V_G$ 35 $\phi_P$ 34 44 GP $\phi_{L1}$

33 45

N N N+ N++

36 37 49 50 P 32

# FIG_5b

$V_G$ 35 $V_{P1}$

$V_{DA}$ $V_{R1}$

$V$

# FIG_5c

$V_G$ 35

$V_{DA}$ 31 $V_{P2}$ $Q_{3SAT}$

$V_{R2}$

$V$

# FIG_6

BALAYAGE DES PORTES DE TRANSFERT 64

BALAYAGE DES DISPOSITIFS DE TRANSFERT VERTICAL

REGISTRE DE LECTURE

MOYENS DE COMMANDE

# FIG_7

BALAYAGE DES PORTES DE TRANSFERT

BALAYAGE DES DISPOSITIFS DE TRANSFERT

REGISTRE DE LECTURE

MOYENS DE COMMANDE

DRAIN

REGISTRE AUXILIAIRE